# EUROPEAN PATENT APPLICATION

(11) **EP 4 565 042 A1**
(43) Date of publication of application: **04.06.2025**
(21) Application number: 24204330.5
(22) Date of filing: 02.10.2024
(51) Int. Cl.: H10K 50/858, H10K 59/80

(54) **LIGHT EMITTING DIODE AND DISPLAY DEVICE USING THE SAME**

(30) Priority: 29.11.2023 KR 20230169339
(71) Applicant: LG Display Co., Ltd., Seoul 07336 (KR)
(72) Inventor: Park, EunYoung, 10845 Gyeonggi-do (KR); Kim, HoSung, 10845 Gyeonggi-do (KR)
(74) Representative: Ter Meer Steinmeister & Partner

(57) **Abstract**

Disclosed is a light emitting diode and a display device using the same. An organic light emitting diode comprises a first electrode, a first organic layer disposed on the first electrode and having a first refractive index, a light emitting layer disposed on the first organic layer and having a second refractive index, a second organic layer disposed on the light emitting layer and having a third refractive index, and a second electrode disposed on the second organic layer, wherein the first refractive index is equal to or greater than the second refractive index, and the second refractive index is greater than the third refractive index.

## Description

This application claims the benefit of the Korean Patent Application No. 10-2023-0169339 filed on November 29, 2023.

### BACKGROUND

### Technical Field

The present disclosure relates to light emitting diode and display device using the same.

### Description of the Related art

As the information society develops, the demand for display devices for displaying images is increasing in various forms. Accordingly, various display devices such as a liquid crystal display (LCD), a plasma display panel (PDP), and an organic light emitting display (OLED) have recently been used.

Among the display devices, the organic light emitting display device is a self-luminous type, has an excellent viewing angle and contrast ratio compared to a liquid crystal display (LCD), and does not require a separate backlight, so it is possible to be lightweight and thin, and power consumption is advantageous. In addition, the organic light emitting display device has the advantage of being able to drive a DC low voltage, a fast response speed, and particularly low manufacturing cost.

The organic light emitting display device has a structure in which an organic light emitting diode including an emission layer is provided between a cathode injecting electrons and an anode injecting holes. The organic light emitting display device is a display device using the principle that when electrons generated at the cathode and holes generated at the anode are injected into the emission layer, the injected electrons and holes combine to generate excitons, and the generated excitons fall from an excited state to a ground state thereby emitting light.

In the organic light emitting display device, the luminance of the light emitted while forming a predetermined angle from the normal direction of the light emitting surface decreases compared to the light emitted in the normal direction of the light emitting surface. That is, the luminance is different when the display device is viewed from the side and when the display device is viewed from the front. In this case, there is a problem that the image quality when viewed from the front and when viewed from the side are different from each other or the color reproduction rate is lowered.

### SUMMARY

An object of is to provide an light emitting diode and display having the same having an improved image quality when viewed from the front and when viewed from the side and/or having an improved color reproduction rate.

The object is solved by the features of the independent claims. Preferred embodiments are given in the dependent claims.

The present disclosure provides a light emitting diode including a first organic layer disposed on a first electrode and contact with an upper surface thereof, a light emitting layer disposed on the first organic layer, and a second organic layer disposed below a second electrode, wherein a first refractive index of the first organic layer is bigger than a third refractive index of the second organic layer so that the luminance of the side is increased, and a display device including the same.

In accordance with an aspect of the present disclosure, the above and other objects can be accomplished by the provision of an organic light emitting diode comprising a first electrode, a first organic layer disposed on the first electrode and having a first refractive index, a light emitting layer disposed on the first organic layer and having a second refractive index, a second organic layer disposed on the light emitting layer and having a third refractive index, and a second electrode disposed on the second organic layer, wherein the first refractive index is equal to or greater than the second refractive index, and the second refractive index is greater than the third refractive index.

Furthermore, the above and other objects can be accomplished by the provision of display device comprising a substrate including a first pixel area, a second pixel area, and a third pixel area, and an organic light emitting diode disposed in the first pixel area, the second pixel area, and the third pixel area, wherein any one of the organic light emitting diodes disposed in each pixel area includes a first electrode, a second electrode disposed on the first electrode, a first organic layer disposed to be in contact with an upper surface of the first electrode, a light emitting layer disposed on the first organic layer, and a second organic layer disposed on the light emitting layer and disposed to be in contact with a lower surface of the second electrode, wherein a first refractive index of the first organic layer is equal to or greater than a second refractive index of the light emitting layer, and the second refractive index of the light emitting layer is greater than a third refractive index of the second organic layer.

In one or more embodiments, the first refractive index may be same as the second refractive index.

In one or more embodiments, the organic light emitting diode may further comprise a third organic layer disposed between the first organic layer and the light emitting layer.

In one or more embodiments, a fourth refractive index of the third organic layer may be the same as the first refractive index.

In one or more embodiments, the first refractive index may be greater than the second refractive index.

In one or more embodiments, a fourth refractive index of the third organic layer may be smaller than the first refractive index, and may be greater than the second refractive index.

In one or more embodiments, a difference between the first refractive index and the third refractive index may be greater than or equal to 0.15 and less than or equal to 0.5.

In one or more embodiments, the difference between the first refractive index and the second refractive index may be smaller than a difference between the second refractive index and the third refractive index.

In one or more embodiments, wherein a ratio of a difference between the first refractive index and the second refractive index to a difference between the second refractive index and the third refractive index may be 4:21 to 16:9.

In one or more embodiments, the first organic layer may include at least one of a hole transport layer and a hole injection layer,

In one or more embodiments, the second organic layer may include at least one of an electron transport layer and an electron injection layer.

In another aspect an organic light emitting diode is provided, comprising: a first electrode; a first organic layer disposed on the first electrode and having a first refractive index; a light emitting layer disposed on the first organic layer and having a second refractive index; a second organic layer disposed on the light emitting layer and having a third refractive index; and a second electrode disposed on the second organic layer, wherein the first refractive index is greater than the third refractive index.

In one or more embodiments, the first refractive index may be equal to or greater than the second refractive index.

In one or more embodiments, the organic light emitting diode may, further comprise a third organic layer disposed between the first organic layer and the light emitting layer.

In one or more embodiments, a fourth refractive index of the third organic layer may be equal to or smaller than the first refractive index, and may be equal to or greater than the second refractive index.

In one or more embodiments, the difference between the first refractive index and the second refractive index may be smaller than a difference between the second refractive index and the third refractive index.

In one or more embodiments, a difference between the first refractive index and the third refractive index may be larger than 0.15 and less than 0.5.

In one or more embodiments, a ratio of a difference between the first refractive index and the second refractive index to a difference between the second refractive index and the third refractive index may be equal to or greater than 4:21, and equal to or less than 16:9.

In one or more embodiments, one organic light emitting diode of the organic light emitting diodes disposed in the first pixel area and the second pixel area may further include a third organic layer between the first organic layer and the light emitting layer,

In one or more embodiments, a fourth refractive index of the third organic layer may be equal to or smaller than the first refractive index of the first organic layer.

In one or more embodiments, an organic light emitting diode disposed in the first pixel area may emit red light.

In one or more embodiments, an organic light emitting diode disposed in the second pixel area may emit green light.

In one or more embodiments, an organic light emitting diode disposed in the third pixel area may emit blue light.

In one or more embodiments, the difference between the first refractive index and the second refractive index may be smaller than a difference between the second refractive index and the third refractive index.

In one or more embodiments, the fourth refractive index may be equal to or greater than the second refractive index.

In one or more embodiments, the light emitting layer of the organic light emitting diode disposed in the third pixel area may be directly provided on the first organic layer.

### BRIEF DESCRIPTION OF THE DRAWINGS

The above and other obj ects, features and other advantages of the present disclosure will be more clearly understood from the following detailed description taken in conjunction with the accompanying drawings, in which:
FIG. 1 is a schematic diagram of a display device of an embodiment of the disclosure.
FIG. 2 is a cross-sectional view of a display device according to an embodiment of the present disclosure. In this case, FIG. 2 corresponds to the cross section I-I' of FIG. 1.
FIG. 3 is a schematic diagram schematically showing a first pixel area, a second pixel area, and a third pixel area of an organic light emitting diode of an embodiment of the disclosure.
FIG. 4 is a cross-sectional view schematically illustrating a portion of an organic light emitting diode according to an embodiment of the present disclosure.
FIG. 5 is a schematic cross-sectional view illustrating a portion of an organic light emitting diode according to another embodiment of the present disclosure.
FIG. 6 is a cross-sectional view schematically illustrating a portion of an organic light emitting diode according to another embodiment of the present disclosure.
FIG. 7 is a schematic cross-sectional view illustrating a portion of an organic light emitting diode according to another embodiment of the present disclosure.
FIG. 8 is a schematic cross-sectional view illustrating a portion of an organic light emitting diode according to another embodiment of the present disclosure.
FIG. 9 is a graph showing luminance of light according to an angle of viewing an organic light emitting diode according to an embodiment of the present disclosure.

### DETAILED DESCRIPTION DISCLOSURE

Advantages and features of the present disclosure, and implementation methods thereof will be clarified through the following embodiments, described with reference to the accompanying drawings. The present disclosure may, however, be embodied in different forms and should not be construed as being limited to the embodiments set forth herein. Rather, these embodiments are provided so that this disclosure will be thorough and complete, and will fully convey the scope of the present disclosure to those skilled in the art. Further, the present disclosure is only defined by the scope of the claims.

The shapes, sizes, ratios, angles, and numbers disclosed in the drawings for describing embodiments of the present disclosure are merely examples, and thus the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted.

In the case in which "comprise," "have," and "include" described in the present specification are used, another part may also be present unless "only" is used. The terms in a singular form may include plural forms unless noted to the contrary.

In construing an element, the element is construed as including an error region although there is no explicit description thereof.

In describing a positional relationship, for example, when the positional order is described as "on," "above," "below," "beneath", and "next," the case of no contact therebetween may be included, unless "just" or "direct" is used.

If it is mentioned that a first element is positioned "on" a second element, it does not mean that the first element is essentially positioned above the second element in the figure. The upper part and the lower part of an object concerned may be changed depending on the orientation of the object. Consequently, the case in which a first element is positioned "on" a second element includes the case in which the first element is positioned "below" the second element as well as the case in which the first element is positioned "above" the second element in the figure or in an actual configuration.

In describing a temporal relationship, for example, when the temporal order is described as "after," "subsequent," "next," and "before," a case which is not continuous may be included, unless "just" or "direct" is used.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element.

It should be understood that the term "at least one" includes all combinations related with any one item. For example, "at least one among a first element, a second element and a third element" may include all combinations of two or more elements selected from the first, second and third elements as well as each element of the first, second and third elements.

Features of various embodiments of the present disclosure may be partially or overall coupled to or combined with each other, and may be variously inter-operated with each other and driven technically The embodiments of the present disclosure may be carried out independently from each other, or may be carried out together in a co-dependent relationship.

In the drawings, the same or similar elements are denoted by the same reference numerals even though they are depicted in different drawings.

In the embodiments of the present disclosure, a source electrode and a drain electrode are distinguished from each other, for convenience of explanation. However, the source electrode and the drain electrode are used interchangeably. Thus, the source electrode may be the drain electrode, and the drain electrode may be the source electrode. Also, the source electrode in any one embodiment of the present disclosure may be the drain electrode in another embodiment of the present disclosure, and the drain electrode in any one embodiment of the present disclosure may be the source electrode in another embodiment of the present disclosure.

In one or more embodiments of the present disclosure, for convenience of explanation, a source region is distinguished from a source electrode, and a drain region is distinguished from a drain electrode. However, embodiments of the present disclosure are not limited to this structure. For example, a source region may be a source electrode, and a drain region may be a drain electrode. Also, a source region may be a drain electrode, and a drain region may be a source electrode.

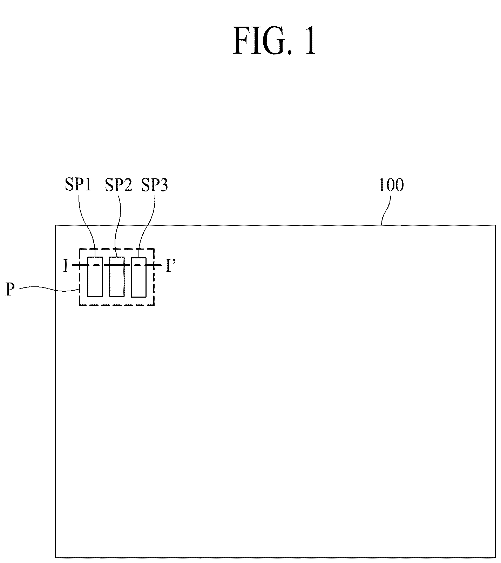

FIG. 1 is a schematic diagram of a display device according to an embodiment of the present disclosure.

As shown in FIG. 1, a display device according to an embodiment of the present disclosure may include a substrate 100 and a plurality of pixels P.

The plurality of pixels P may be provided on the substrate 100. Although not specifically illustrated, an m plurality of pixels may be provided in a first direction, for example, a horizontal direction, and an n plurality of pixels may be provided in a second direction, for example, a vertical direction, of the substrate 100. As a result, the display device according to an embodiment of the present disclosure may include an m number of pixels P in a horizontal direction and an n number of pixels P in a vertical direction, where m and n can be positive numbers such as positive integers.

Each of the plurality of pixels P may include a first pixel area SP1, a second pixel area SP2, and a third pixel area SP3 emitting different colors of light, respectively. In this case, the first pixel area SP1, the second pixel area SP2, and the third pixel area SP3 may emit red, green, and blue light, respectively, but are not limited thereto and can also be referred to a first sub-pixel area, a second sub-pixel area and a third sub-pixel area, respectively. Furthermore, an additional pixel area emitting white light may be included in each pixel P. In addition, different configurations, shapes, sizes and variations of each pixel P and/or each pixel area can be part of the present disclosure.

Meanwhile, in FIG. 1, the first pixel area SP1, the second pixel area SP2, and the third pixel area SP3 in the form of stripes are provided, but the present disclosure is not limited thereto, and the plurality of pixels P may be provided on the substrate 100 in various types of pixel arrangements according to technical common sense in the art.

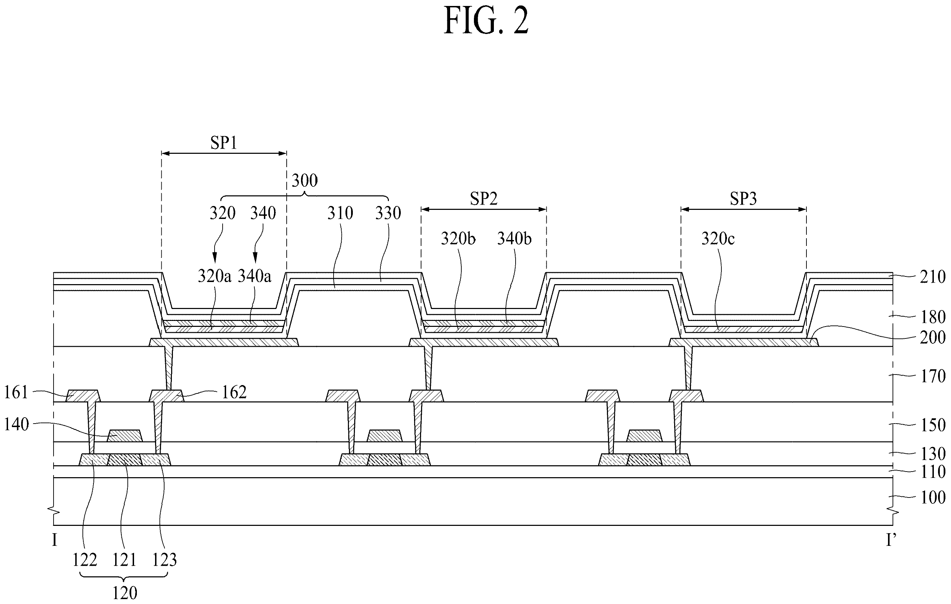

FIG. 2 is a cross-sectional view of a display device according to an embodiment of the present disclosure. In this case, FIG. 2 corresponds to the cross section I-I' of FIG. 1.

As shown in FIG. 2, the display device according to an embodiment of the present disclosure may include a substrate 100, a buffer layer 110, an active layer 120, a gate insulating layer 130, a gate electrode 140, an interlayer insulating layer 150, a source electrode 161, a drain electrode 162, a planarization layer 170, a bank 180, a first electrode 200, a second electrode 210, and an organic material layer 300.

The substrate 100 may be formed of glass or plastic. In particular, the substrate 100 may be formed of transparent plastic having flexible characteristics, for example, polyimide. When polyimide is used as the substrate 100, considering that a high-temperature deposition process is performed on the substrate 100, heat-resistant polyimide capable of withstanding high temperatures may be used. Although not shown in a drawing, the substrate 100 may include a plurality of substrates such as a first substrate and a second substrate.

The buffer layer 110 is formed on the substrate 100. The buffer layer 110 may block air and moisture to protect the active layer 120. The buffer layer 110 may be made of an inorganic insulating material such as silicon oxide, silicon nitride, or metal oxide, but is not limited thereto and may be made of an organic insulating material.

The active layer 120 may be formed on the buffer layer 110. The active layer 120 may be formed of a silicon (Si)-based semiconductor material or an oxide-based semiconductor material. A light blocking layer for blocking external light incident on the active layer 120 may be additionally formed between the buffer layer 110 and the active layer 120.

The active layer 120 may include a channel part 121, a first connection part 122 provided on one side of the channel part 121, for example, a left side, and a second connection part 123 provided on another side of the channel part 121, for example, on the right side. The first connection part 122 and the second connection part 123 have superior conductivity characteristics compared to the channel part 121, and thus may be used as a wiring or an electrode. Meanwhile, when the active layer 120 is formed of, for example, an oxide semiconductor, a conducting process of the first connection part 122 and the second connection part 123 may be performed using the gate electrode 140 as a mask.

The gate insulating layer 130 may be formed on the buffer layer 110 and the active layer 120.

The gate insulating layer 130 may include a silicon nitride layer SiNx or a silicon oxide layer SiOx, but is not limited thereto. The gate insulating layer 130 may have a single layer structure or a multilayer structure.

The gate electrode 140 may be formed on the gate insulating layer 130.

The gate electrode 140 may include at least one among an aluminum-based metal such as aluminum Al or an aluminum alloy, a silver-based metal such as silver Ag or a silver alloy, a copper-based metal such as copper Cu or a copper alloy, a molybdenum-based metal such as molybdenum Mo or a molybdenum alloy, and chromium Cr, tantalum Ta, neodymium Nd, and titanium Ti. The gate electrode 140 may have a multilayer structure including at least two different conductor films.

The interlayer insulating layer 150 is formed on the gate insulating layer 130 and the gate electrode 140.

The interlayer insulating layer 150 may be formed of a single layer or a plurality of layers including an inorganic insulating material and/or an organic insulating material.

A contact hole may be formed in the interlayer insulating layer 150. In this case, one side of the active layer 120, for example, the first connection part 122 may be exposed by the contact hole, and another side of the active layer 120, for example, the second connection part 123 may be exposed by the contact hole.

The source electrode 161 and the drain electrode 162 may be formed on the interlayer insulating layer 150.

The source electrode 161 and the drain electrode 162 may include at least one of aluminum-based metals such as aluminum Al or aluminum alloy, silver-based metals such as silver Ag or silver alloy, copper-based metals such as copper Cu or copper alloy, molybdenum-based metals such as molybdenum Mo or molybdenum alloy, chromium Cr, tantalum Ta, neodymium Nd, and titanium Ti.

The source electrode 161 may be electrically connected to one side of the active layer 120, for example, the first connection part 122 through the contact hole, and the drain electrode 162 may be electrically connected to another side of the active layer 120, for example, the second connection part 123 through the contact hole.

The planarization layer 170 may be formed on the source electrode 161 and the drain electrode 162 to planarize the upper surface of the planarization layer 170.

A contact hole may be provided in the planarization layer 170 to expose a portion of the upper surface of the drain electrode 162. Meanwhile, in some cases, a portion of the upper surface of the source electrode 161 may be exposed by the contact hole.

The planarization layer 170 may be formed of an organic insulating layer material. For example, the planarization layer 170 may be formed of an organic insulating material such as acrylic resin, epoxy resin, phenolic resin, polyamide resin, or polyimide resin.

The first electrode 200 may be formed on the planarization layer 170. In this case, the first electrode 200 may be patterned in the first pixel area SP1, the second pixel area SP2, and the third pixel area SP3, respectively.

The first electrode 200 may be electrically connected to the drain electrode 162 through the contact hole provided in the planarization layer 170. The first electrode 200 may function as an anode.

The bank 180 may be provided to cover an edge of the first electrode 200 to define a light emitting area. Thus, an upper surface area of the first electrode 200, which is exposed without being covered by the bank 180, becomes a light emitting area.

The bank 180 may be formed of an organic layer such as an acrylic resin, an epoxy resin, a phenolic resin, a polyamide resin, a polyimide resin, or the like.

The organic material layer 300 may be provided on the first electrode 200. The organic material layer 300 may include a first organic layer 310, light emitting layers 320a, 320b, and 320c, a second organic layer 330, and third organic layers 340a and 340b. The organic material layer 300 may include the light emitting layers 320a, 320b, and 320c that actually emit light while holes and electrons moved in the first electrode 200 and the second electrode 210 are combined to form excitons.

The first organic layer 310 and the second organic layer 330 may be formed on upper surfaces of the first electrode 200 and the bank 180, and the light emitting layers 320a, 320b, and 320c may be patterned for each pixel.

The third organic layers 340a and 340b may include the third organic layer 340a formed in the first pixel area SP1 and the third organic layer 340b formed in the second pixel area SP2. In FIG. 2, the third organic layers 340a and 340b are not formed in the third pixel area SP3, but are not limited thereto.

The third organic layer 340a provided in the first pixel area SP1 and the third organic layer 340b provided in the second pixel area SP2 may be formed on the light emitting layers 320a and 320b, respectively. Meanwhile, a method of forming the third organic layers 340a and 340b is not limited thereto, and the third organic layers 340a and 340b may be continuously provided in the first pixel area SP1 and the second pixel area SP2.

Each of the third organic layers 340a and 340b may function to adjust an optical distance in the first pixel area SP1 and the second pixel area SP2, or may adjust a threshold voltage Vth of the first pixel area SP1 and the second pixel area SP2, and in this case, a problem in which a leakage current flows between the first pixel area SP1 and the second pixel area SP2 may be prevented.

The light emitting layers 320a, 320b, and 320c may include a first light emitting layer 320a patterned in the first pixel area SP1, a second light emitting layer 320b patterned in the second pixel area SP2, and a third light emitting layer 320c patterned in the third pixel area SP3. In this case, the first light emitting layer 320a, the second light emitting layer 320b, and the third light emitting layer 320c may include, for example, red, green, and blue light emitting layers, respectively, but are not limited thereto.

The second electrode 210 may be provided on the organic material layer 300. The second electrode 210 may function as a cathode.

Although not shown, an encapsulation layer for preventing penetration of moisture or oxygen may be additionally formed on the second electrode 210.

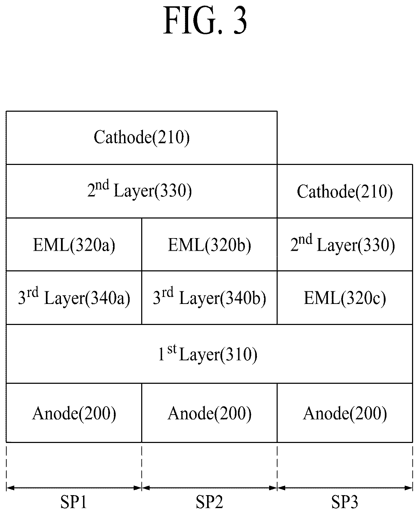

FIG. 3 is a schematic diagram schematically showing a first pixel area, a second pixel area, and a third pixel area of an organic light emitting diode according to an embodiment of the present disclosure. The organic light emitting diode of FIG. 3 can be part of the display device of the present disclosure.

As shown in FIG. 3, the organic light emitting diode according to an embodiment of the present disclosure may include a first pixel area SP1, a second pixel area SP2, and a third pixel area SP3.

The first electrode 200 may be patterned in each of the first pixel area SP1, the second pixel area SP2, and the third pixel area SP3.

The first electrode 200 may be a reflective electrode. The first electrode 200 may include any one of silver, magnesium, copper, aluminum, platinum, palladium, gold, molybdenum, titanium, and compounds thereof.

The first organic layer 310 may be provided on the first electrode 200. The first organic layer 310 may be formed on the entire surface of the first pixel area SP1, the second pixel area SP2, and the third pixel area SP3. However, the present disclosure is not limited thereto. The lower surface of the first organic layer 310 may be in contact with the upper surface of the first electrode 200. However, the present disclosure is not limited thereto.

The first organic layer 310 may be at least one of a hole transfer layer HTL, a hole injection layer HIL, and an electron blocking layer EBL. According to an embodiment of the present disclosure, the first organic layer 310 may be, for example, a hole transfer layer HTL.

The first organic layer 310 may be provided to be in contact with the upper surface of the first electrode 200, and may move the hole moved from the first electrode 200.

The third organic layers 340a and 340b are provided on the first organic layer 310. In this case, the third organic layers 340a and 340b may be provided in the first pixel area SP1 and the second pixel area SP2, but may not be provided in the third pixel area SP3.

The third organic layer 340a provided in the first pixel area SP1 may be provided between the first organic layer 310 and the light emitting layer EML 320a.

The third organic layer 340a may realize a microcavity characteristic between the first electrode 200 and the second electrode 210 by adjusting a distance between the first electrode 200 and the second electrode 210, that is, a resonance distance. The microcavity characteristic refers to a characteristic in which when the distance between the first electrode 200 and the second electrode 210 becomes an integral multiple of the half wavelength λ/2 of the light emitted from the first pixel area SP1, reinforcement interference occurs and light is amplified, and the degree to which light is amplified is continuously increased by repeating the reflection and re-reflection processes between the first electrode 200 and the second electrode 210, such that the external extraction efficiency of light is improved.

Furthermore, the third organic layer 340a may adjust a threshold voltage Vth required to emit light of the light emitting layer 320a to prevent the current generated in the first pixel area SP1 from leaking to another pixel area.

The third organic layer 340b provided in the second pixel area SP2 may be provided between the first organic layer 310 and the light emitting layer EML 320b.

In this case, the third organic layer 340b provided in the second pixel area SP2 may perform the same function as the third organic layer 340a provided in the first pixel area SP1, and thus a repeated description thereof will be omitted.

The light emitting layer EML 320a provided in the first pixel area SP1 may be provided on the third organic layer 340a. In this case, the light emitting layer EML 320a provided in the first pixel area SP1 may emit red light, for example. The light emitting layer EML 320b provided in the second pixel area SP2 may be provided on the third organic layer 340b, and in this case, the light emitting layer 320b provided in the second pixel area SP2 may emit green light, for example. Furthermore, the light emitting layer EML 320c provided in the third pixel area SP3 may be directly provided on the first organic layer 310, but is not limited thereto. In this case, the light emitting layer EML 320c provided in the third pixel area SP3 may emit blue light, for example.

The second organic layer 330 may be provided in all of the first pixel area SP1, the second pixel area SP2, and the third pixel area SP3 as a common layer. The second organic layer 330 may be provided on the light emitting layers 320a, 320b, and 320c. The third organic layer 340 may be at least one of an electron transport layer ETL, an electron injection layer EIL, and a hole blocking layer HBL. The third organic layer 340 may be, for example, an electron transport layer ETL.

The second electrode 210 may be provided in all of the first pixel area SP1, the second pixel area SP2, and the third pixel area SP3 as a common layer. Specifically, the second electrode 210 may be provided on the second organic layer 330. Therefore, the top surface of the second organic layer 330 may be in contact with the bottom surface of the second electrode 210. However, the present disclosure is not limited thereto.

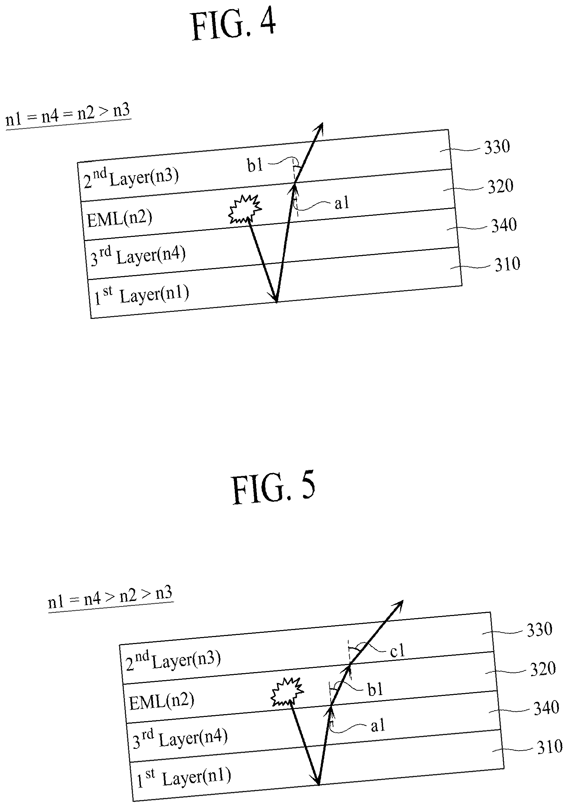

According to an embodiment of the present disclosure, the refractive index of the first organic layer 310 may be greater than the refractive index of the second organic layer 330, and other layers provided between the first organic layer 310 and the second organic layer 330 may gradually decrease in the refractive index from the first electrode 200 toward the second electrode 210. In this case, since the light emitted from the light emitting layer 320a, 320b, and 320c is reflected from the first electrode 200 and moves to the upper surface of the second electrode 210, the angle of refraction increases, the luminance at a side surface of an organic light emitting diode according to an embodiment of the present disclosure may be improved. Meanwhile, this will be described in more detail with reference to FIGS. 4 to 8 below.

FIG. 4 is a cross-sectional view schematically illustrating a portion of an organic light emitting diode according to an embodiment of the present disclosure.

A principle of improving a viewing angle on a side surface in the first pixel area (see SP1 of FIG. 3) or the second pixel area (see SP2 of FIG. 3) of the organic light emitting diode according to an embodiment of the present disclosure will be described in detail with reference to FIG. 4. Meanwhile, an embodiment of FIG. 4 corresponds to a diagram schematically illustrating any one of the first pixel area SP1 and the second pixel area SP2 of FIG. 3, and thus repeated descriptions of the same components will be omitted.

As shown in FIG. 4, in the organic light emitting diode according to an embodiment of the present disclosure, a first organic layer 1st layer 310, a third organic layer 3rd layer 340, light emitting layers EML 320 and a second organic layer 330 are sequentially formed from the bottom of the drawing. According to an embodiment of the present disclosure, the first organic layer 1st layer 310 may have a first refractive index n1, the light emitting layers EML 320 may have a second refractive index n2, the second organic layer 2nd layer 330 may have a third refractive index n3, and the third organic layer 340 may have a fourth refractive index n4.

According to an embodiment of the present disclosure, the first refractive index n1 of the first organic layer 310 may be greater than the third refractive index n3 of the second organic layer 330, and the first refractive index n1 of the first organic layer 310 may be equal to the fourth refractive index n4 of the third organic layer 340 and the second refractive index n2 of the light emitting layer 320. By forming in this way, a viewing angle in a side surface of light emitted from the first pixel area (see SP1 of FIG. 3) or the second pixel area (see SP2 of FIG. 3) may be improved.

More specifically, the light emitted from the light emitting layer 320 may pass the light emitting layer 320, the third organic layer 340, and the first organic layer 310 in order, may be reflected by the first electrode 200 (see FIG. 3) provided on the lower surface of the first organic layer 310, and may pass the first organic layer 310, the third organic layer 340, the light emitting layer 320, and the second organic layer 330 in order, and may be emitted to the upper surface of the second organic layer 330.

Since the first refractive index n1, the second refractive index n2, and the fourth refractive index n4 are the same, light that sequentially passes the first organic layer 310, the third organic layer 340, and the light emitting layer 320 may be not refracted. The light may travel toward a boundary surface between the light emitting layer 320 and the second organic layer 330 at a first angle a1, and since the second refractive index n2 of the light emitting layer 320 is greater than the third refractive index n3 of the second organic layer 330, the light may be refracted at a second angle b1 and emitted from the boundary surface between the light emitting layer 320 and the second organic layer 330. In this case, the second angle b1 may be formed to be greater than the first angle a1. The first angle a1 may be defined as an angle formed by the light traveling from a normal line of an boundary surface between the light emitting layer 320 and the second organic layer 330 toward the boundary surface between the light emitting layer 320 and the second organic layer 330, and the second angle b1 may be defined as an angle formed by the light emitted from the boundary surface between the light emitting layer 320 and the second organic layer 330 from a normal line of an boundary surface between the light emitting layer 320 and the second organic layer 330.

Meanwhile, the first angle a1 and the second angle b1 may be adjusted to a level according to knowledge of the art so that the total reflection of the light may not be occur at each boundary surface. Thus, the light may not be trapped inside the light emitting layer 320 or the second organic layer 330.

According to an embodiment of the present disclosure, since light traveling in a direction away from the boundary surface between the light emitting layer 320 and the second organic layer 330 is emitted at the second angle b1 greater than the first angle a1, the luminance on the side of the organic light emitting diode according to an embodiment of the present disclosure may increase, thereby improving the luminance viewing angle of the display device.

Table 1 shows the luminance at an angle of 45 degrees with respect to a difference value between the first refractive index n1 of the first organic layer 310 and the third refractive index n3 of the second organic layer 330 in a case in which the organic light emitting diode according to an embodiment of the present disclosure is the first pixel area SP1 of FIG. 3. In this case, the luminance measured at an angle of 45 degrees in Examples 1a to 1c is relatively shown based on 100% of the luminance measured at an angle of 45 degrees in Comparative Example 1.

**[table 1]**

| | n1-n3 | n1 | n4 | n2 | n3 | Luminance(%, @45°) |
|---|---|---|---|---|---|---|
| Comparative example 1 | -0.07 | 1.84 | 1.92 | 1.95 | 1.91 | 100% |
| Example 1a | 0.15 | 2 | 2 | 2 | 1.85 | 119% |
| Example 1b | 0.2 | 2 | 2 | 2 | 1.8 | 122% |
| Example 1c | 0.25 | 2 | 2 | 2 | 1.75 | 125% |

As shown in Table 1, in the examples 1a, 1b, and 1c in which the first refractive index n1 of the first organic layer 310 is greater than the third refractive index n3 of the second organic layer 330, higher luminance can be obtained compared to comparative example 1 in which the first refractive index n1 of the first organic layer 310 is smaller than the third refractive index n3 of the second organic layer 330. As a result, as shown in Examples 1a to 1c and Comparative Example 1, since the first refractive index n1 of the first organic layer 310 is greater than the third refractive index n3 of the second organic layer 330, the luminance on the side of the organic light emitting diode according to an embodiment of the present disclosure may be improved, and thus the luminance viewing angle of the organic light emitting diode may be improved.

Table 2 shows the luminance at an angle of 45 degrees with respect to the difference value between the first refractive index n1 of the first organic layer 310 and the third refractive index n3 of the second organic layer 330 in a case in which the organic light emitting diode according to an embodiment of the present disclosure is the second pixel area SP2 of FIG. 3. In this case, the luminance measured at a 45 degrees of Examples 2a to 2c is relatively represented based on 100% of the luminance measured at a 45 degrees of Comparative Example 2.

**[table 2]**

| | n1-n3 | n1 | n4 | n2 | n3 | Luminance(%, @45°) |
|---|---|---|---|---|---|---|
| Comparative example 2 | -0.07 | 1.84 | 1.84 | 2 | 1.91 | 100% |
| Example 2a | 0.15 | 2 | 2 | 2 | 1.85 | 124% |
| Example 2b | 0.2 | 2 | 2 | 2 | 1.8 | 124% |
| Example 2c | 0.25 | 2 | 2 | 2 | 1.75 | 127% |

As shown in Table 2, in the examples 2a, 2b, and 2c in which the first refractive index n1 of the first organic layer 310 is greater than the third refractive index n3 of the second organic layer 330, higher luminance can be obtained compared to comparative example 2 in which in which the first refractive index n1 of the first organic layer 310 is smaller than the third refractive index n3 of the second organic layer 330. As a result, as shown in Examples 2a to 2c and Comparative Example 2, since the first refractive index n1 of the first organic layer 310 is greater than the third refractive index n3 of the second organic layer 330, the luminance on a side surface of an organic light emitting diode according to an embodiment of the present disclosure may be improved, and thus the luminance viewing angle of the organic light emitting diode may be improved.

FIG. 5 is a schematic cross-sectional view illustrating a portion of an organic light emitting diode according to another embodiment of the present disclosure. Meanwhile, an embodiment of FIG. 5 is the same as an embodiment of FIG. 4, except for a relationship between a refractive index of a light emitting layer and a refractive index of a third organic layer, thus different configurations will be mainly described below.

According to another embodiment of the present disclosure, the first refractive index n1 of the first organic layer 310 may be greater than the third refractive index n3 of the second organic layer 330, the fourth refractive index n4 of the third organic layer 340 may be greater than the second refractive index n2 of the light emitting layer 320, the second refractive index n2 of the light emitting layer 320 may be greater than the third refractive index n3 of the second organic layer 330, and the first refractive index n1 of the first organic layer 310 and the fourth refractive index n4 of the third organic layer 340 may be the same. By forming in this way, a viewing angle in a side surface of light emitted from the first pixel area (see SP1 of FIG. 3) or the second pixel area (see SP2 of FIG. 3) may be improved.

Since the first refractive index n1 and the fourth refractive index n4 are the same, light that sequentially passes the first organic layer 310 and the third organic layer 340 may be not refracted. The light may travel toward the boundary surface between the third organic layer 340 and the light emitting layer 320 at a first angle a1, and since the fourth refractive index n4 of the third organic layer 340 is greater than the second refractive index n2 of the light emitting layer 320, the light may be refracted at a second angle b1 and emitted from the boundary surface between the third organic layer 340 and the light emitting layer 320. In this case, the second angle b1 may be formed to be greater than the first angle a1. The first angle a1 may be defined as an angle formed by the light traveling toward the boundary surface between the light emitting layer 320 and the third organic layer 340 from a normal line of the boundary surface between the light emitting layer 320 and the third organic layer 340, and the second angle b1 may be defined as an angle formed by the light emitted from the boundary surface between the light emitting layer 320 and the third organic layer 340 from a normal line of the boundary surface between the light emitting layer 320 and the third organic layer 340.

Furthermore, since the light travels toward the boundary surface between the light emitting layer 320 and the second organic layer 330 at the second angle b1, and the second refractive index n2 of the light emitting layer 320 is greater than the third refractive index n3 of the second organic layer 330, the light is refracted at the third angle c1 and emitted from the boundary surface between the light emitting layer 320 and the second organic layer 330. In this case, the third angle c1 may be formed to be greater than the second angle b1. Accordingly, the third angle c1 is formed to be greater than the first angle a1. The third angle c1 may be defined as an angle formed by the light emitted from the boundary surface between the light emitting layer 320 and the second organic layer 330 from a normal line of the boundary surface between the light emitting layer 320 and the second organic layer 330.

Meanwhile, the first angle a1, the second angle b1, and the third angle c1 may be adjusted to a level according to knowledge of the art so that the total reflection of the light may not be occur at each boundary surface. Thus, the light may not be trapped inside the light emitting layer 320, the second organic layer 330, or the third organic layer 340.

According to another embodiment of the present disclosure, since light traveling in a direction away from the boundary surface between the light emitting layer 320 and the second organic layer 330 is emitted at the third angle c1 greater than the first angle a1, luminance on the side of the organic light emitting diode according to another embodiment of the present disclosure may increase, thereby improving the luminance viewing angle of the display device.

Table 3 shows the luminance at an angle of 45 degrees with respect to a difference value between the first refractive index n1 of the first organic layer 310 and the third refractive index n3 of the second organic layer 330 in a case in which the organic light emitting diode according to another embodiment of the present disclosure is the first pixel area SP1 of FIG. 3. In this case, the luminance measured at an angle of 45 degrees in Examples 3a to 3c is relatively shown based on 100% of the luminance measured at an angle of 45 degrees in Comparative Example 1.

**[table 3]**

| | n1-n3 | n1 | n4 | n2 | n3 | Luminance(%, @45°) |
|---|---|---|---|---|---|---|
| Comparative example1 | -0.07 | 1.84 | 1.92 | 1.95 | 1.91 | 100% |
| Example3 a | 0.15 | 2 | 2 | 1.93 | 1.85 | 123% |
| Example3b | 0.2 | 2 | 2 | 1.9 | 1.8 | 129% |
| Examples c | 0.25 | 2 | 2 | 1.88 | 1.75 | 131% |

As shown in Table 3, in the examples 3a, 3b, and 3c in which the first refractive index n1 of the first organic layer 310 is greater than the third refractive index n3 of the second organic layer 330, higher luminance can be obtained compared to comparative example 1 in which the first refractive index n1 of the first organic layer 310 is smaller than the third refractive index n3 of the second organic layer 330. As a result of examining Examples 3a to 3c and Comparative Example 1, since the first refractive index n1 of the first organic layer 310 is greater than the third refractive index n3 of the second organic layer 330, the luminance at a side surface of an organic light emitting diode according to another embodiment of the present disclosure may be improved, and thus the luminance viewing angle of the organic light emitting diode may be improved. Furthermore, referring to Tables 1 and 3, it may be seen that the luminance in which the first refractive index n1 of the first organic layer 310 and the fourth refractive index n4 of the third organic layer 340 are the same, and the second refractive index n2 of the light emitting layer 320 is smaller than the first refractive index n1 (or the fourth refractive index n4)(examples 3a to 3c), is relatively higher than that in which the first refractive index n1 of the first organic layer 310, the fourth refractive index n4 of the third organic layer 340, and the second refractive index n2 of the light emitting layer 320 are all the same (examples 1a to 1c).

Table 4 shows the luminance at an angle of 45 degrees with respect to a difference value between the first refractive index n1 of the first organic layer 310 and the third refractive index n3 of the second organic layer 330 in a case in which the organic light emitting diode according to another embodiment of the present disclosure is the second pixel area SP2 of FIG. 3. In this case, the luminance measured at an angle of 45 degrees in Examples 4a to 4c is relatively represented based on 100% of the luminance measured at an angle of 45 degrees in Comparative Example 2.

**[table 4]**

| | n1-n3 | n1 | n4 | n2 | n3 | Luminance(%, @45°) |
|---|---|---|---|---|---|---|
| Comparative example2 | -0.07 | 1.84 | 1.84 | 2 | 1.91 | 100% |
| Example4a | 0.15 | 2 | 2 | 1.93 | 1.85 | 126% |
| Example4b | 0.2 | 2 | 2 | 1.9 | 1.8 | 128% |
| Example4c | 0.25 | 2 | 2 | 1.88 | 1.75 | 131% |

As shown in Table 4, in the examples 4a, 4b, and 4c in which the first refractive index n1 of the first organic layer 310 is greater than the third refractive index n3 of the second organic layer 330, higher luminance can be obtained compared to comparative example 2 in which the first refractive index n1 of the first organic layer 310 is smaller than the third refractive index n3 of the second organic layer 330. As a result of examining Examples 4a to 4c and Comparative Example 2, since the first refractive index n1 of the first organic layer 310 is greater than the third refractive index n3 of the second organic layer 330, the luminance on a side surface of an organic light emitting diode according to another embodiment of the present disclosure may be improved, and thus the luminance viewing angle of the organic light emitting diode may be improved. Furthermore, referring to Tables 2 and 4, it may be seen that the luminance in which the first refractive index n1 of the first organic layer 310 and the fourth refractive index n4 of the third organic layer 340 are the same, and the second refractive index n2 of the light emitting layer 320 is smaller than the first refractive index n1 or the fourth refractive index n4 (Examples 4a to 4c), is relatively higher than that in which the first refractive index n1 of the first organic layer 310, the fourth refractive index n4 of the third organic layer 340, and the second refractive index n2 of the light emitting layer 320 are all the same (Examples 2a to 2c).

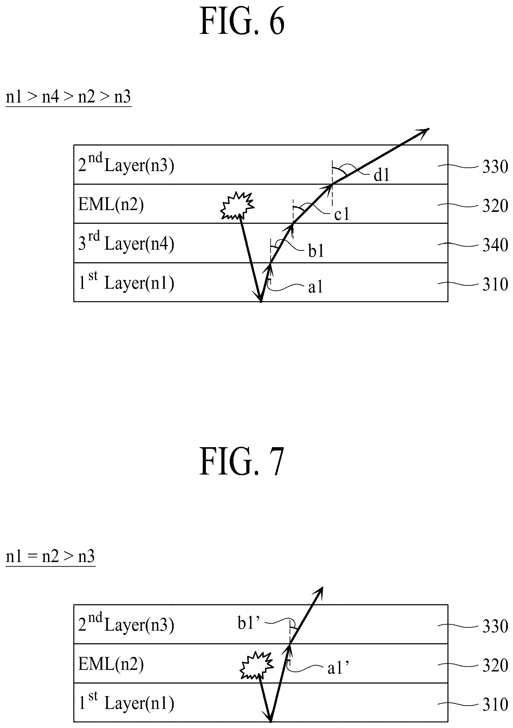

FIG. 6 is a cross-sectional view schematically illustrating a portion of an organic light emitting diode according to another embodiment of the present disclosure. Meanwhile, an embodiment of FIG. 6 is the same as an embodiment of FIG. 4, except for a relationship between a refractive index of a first organic layer and a refractive index of a third organic layer and a relationship between a refractive index of a light emitting layer and a refractive index of a third organic layer, thus different configurations will be mainly described below.

According to another embodiment of the present disclosure, the first refractive index n1 of the first organic layer 310 may be greater than the third refractive index n3 of the second organic layer 330, the fourth refractive index n4 of the third organic layer 340 may be greater than the second refractive index n2 of the light emitting layer 320, the second refractive index n2 of the light emitting layer 320 may be greater than the third refractive index n3 of the second organic layer 330, and the first refractive index n1 of the first organic layer 310 may be greater than the fourth refractive index n4 of the third organic layer 340. By forming in this way, a viewing angle in a side surface of light emitted from the first pixel area (see SP1 of FIG. 3) or the second pixel area (see SP2 of FIG. 3) may be improved.

Since the first refractive index n1, the fourth refractive index n4, the second refractive index n2, and the third refractive index n3 are provided to decrease in order, the light may be refracted every time it passes through the boundary surface of each layer. Specifically, the light may travel toward the boundary surface between the first organic layer 310 and the third organic layer 340 at a first angle a1, and since the first refractive index n1 of the first organic layer 310 is higher than the fourth refractive index n4 of the third organic layer 340, the light may be refracted at a second angle b1 and emitted from the boundary surface between the first organic layer 310 and the third organic layer 340. In this case, the second angle b1 may be formed to be greater than the first angle a1. The first angle a1 may be defined as an angle formed by the light traveling from a normal line of an boundary surface between the first organic layer 310 and the third organic layer 340 toward the boundary surface between the first organic layer 310 and the third organic layer 340, and the second angle b1 may be defined as an angle formed by the light emitted from the boundary surface between the first organic layer 310 and the third organic layer 340 from a normal line of an boundary surface between the first organic layer 310 and the third organic layer 340.

Next, the light may travel toward the boundary surface between the third organic layer 340 and the light emitting layer 320 at the second angle b1, and since the fourth refractive index n4 of the third organic layer 340 is greater than the second refractive index n2 of the light emitting layer 320, the light may be refracted at the third angle c1 and emitted from the boundary surface between the third organic layer 340 and the light emitting layer 320. In this case, the third angle c1 may be formed to be greater than the second angle b1. The third angle c1 may be defined as an angle formed by the light emitted from the boundary surface between the light emitting layer 320 and the third organic layer 340 from a normal line of the boundary surface between the light emitting layer 320 and the third organic layer 340.

Furthermore, since the light travels toward the boundary surface between the light emitting layer 320 and the second organic layer 330 at the third angle c1, and the second refractive index n2 of the light emitting layer 320 is greater than the third refractive index n3 of the second organic layer 330, the light may be refracted at the fourth angle d1 and emitted from the boundary surface between the light emitting layer 320 and the second organic layer 330. In this case, the fourth angle d1 may be formed to be greater than the third angle c1. Thus, the fourth angle d1 may be formed to be greater than the first angle a1. The fourth angle d1 may be defined as an angle formed by the light emitted from the boundary surface between the light emitting layer 320 and the second organic layer 330 from a normal line of the boundary surface between the light emitting layer 320 and the second organic layer 330.

Meanwhile, the first angle a1, the second angle b1, the third angle c1, and the fourth angle d1 may be adjusted to a level according to knowledge of the art so that the total reflection of the light may not be occur at each boundary surface. Thus, the light may not be trapped inside the first organic layer 310, the light emitting layer 320, the second organic layer 330, or the third organic layer 340.

According to another embodiment of the present disclosure, since light traveling in a direction away from the boundary surface between the light emitting layer 320 and the second organic layer 330 is emitted at the fourth angle d1 greater than the first angle a1, luminance on the side of the organic light emitting diode according to another embodiment of the present disclosure may increase, thereby improving the luminance viewing angle of the display device.

Table 5 shows the luminance at an angle of 45 degrees with respect to a difference value between the first refractive index n1 of the first organic layer 310 and the third refractive index n3 of the second organic layer 330 in a case in which the organic light emitting diode according to another embodiment of the present disclosure is the first pixel area SP1 of FIG. 3. In this case, the luminance measured at an angle of 45 degrees in Examples 5a to 5c is relatively represented based on 100% of the luminance measured at an angle of 45 degrees in Comparative Example 1.

**[table 5]**

| | n1-n3 | n1 | n4 | n2 | n3 | Luminance(%, @45°) |
|---|---|---|---|---|---|---|
| Comparative example1 | -0.07 | 1.84 | 1.92 | 1.95 | 1.91 | 100% |
| Example 5a | 0.15 | 2 | 1.95 | 1.9 | 1.85 | 127% |
| Example 5b | 0.2 | 2 | 1.93 | 1.87 | 1.8 | 131% |
| Example 5c | 0.25 | 2 | 1.92 | 1.83 | 1.75 | 139% |

As shown in Table 5, in the examples 5a, 5b, and 5c in which the first refractive index n1 of the first organic layer 310 is greater than the third refractive index n3 of the second organic layer 330, higher luminance can be obtained compared to comparative example 1 in which the first refractive index n1 of the first organic layer 310 is smaller than the third refractive index n3 of the second organic layer 330. As a result of examining Examples 5a to 5c and Comparative Example 1, since the first refractive index n1 of the first organic layer 310 is greater than the third refractive index n3 of the second organic layer 330, the luminance at a side surface of an organic light emitting diode according to another embodiment of the present disclosure may be improved, and thus the luminance viewing angle of the organic light emitting diode may be improved. Furthermore, referring to Table 1, Table 3, and Table 5, it may be seen that the luminance in which the first refractive index n1, the fourth refractive index n4, the second refractive index n2, and the third refractive index n3 are sequentially lowered (Examples 5a to 5c), is relatively higher than that in which the first refractive index n1 of the first organic layer 310, the fourth refractive index n4 of the third organic layer 340 and the second refractive index n2 of the light emitting layer 320 are all the same (Examples 1a to 1c) and that in which the first refractive index n1 of the first organic layer 310 and the fourth refractive index n4 of the third organic layer 340 are the same, and the second refractive index n2 of the light emitting layer 320 is smaller than the first refractive index n1 (or the fourth refractive index n4) (Examples 3a to 3c).

Table 6 shows the luminance at an angle of 45 degrees with respect to a difference value between the first refractive index n1 of the first organic layer 310 and the third refractive index n3 of the second organic layer 330 in a case in which the organic light emitting diode according to another embodiment of the present disclosure is the second pixel area SP2 of FIG. 3. In this case, the luminance measured at an angle of 45 degrees in Examples 6a to 6c is relatively represented based on 100% of the luminance measured at an angle of 45 degrees in Comparative Example 2.

**[table 6]**

| | n1-n3 | n1 | n4 | n2 | n3 | Luminance(%, @45°) |
|---|---|---|---|---|---|---|
| Comparative example2 | -0.07 | 1.84 | 1.84 | 2 | 1.91 | 100% |
| Example 6a | 0.15 | 2 | 1.95 | 1.9 | 1.85 | 128% |
| Example 6b | 0.2 | 2 | 1.93 | 1.87 | 1.8 | 131% |
| Example 6c | 0.25 | 2 | 1.92 | 1.83 | 1.75 | 138% |

As shown in Table 6, in the examples 6a, 6b, and 6c in which the first refractive index n1 of the first organic layer 310 is greater than the third refractive index n3 of the second organic layer 330, higher luminance can be obtained compared to comparative example 2 in which the first refractive index n1 of the first organic layer 310 is smaller than the third refractive index n3 of the second organic layer 330. As a result of examining Examples 6a to 6c and Comparative Example 2, since the first refractive index n1 of the first organic layer 310 is greater than the third refractive index n3 of the second organic layer 330, the luminance on a side surface of an organic light emitting diode according to another embodiment of the present disclosure may be improved, and thus the luminance viewing angle of the organic light emitting diode may be improved. Furthermore, referring to Table 2, Table 4, and Table 6, it may be seen that the luminance in which the first refractive index n1, the fourth refractive index n4, the second refractive index n2, and the third refractive index n3 are sequentially lowered (Examples 6a to 6c), is relatively higher than that in which the first refractive index n1 of the first organic layer 310, the fourth refractive index n4 of the third organic layer 340 and the second refractive index n2 of the light emitting layer 320 are all the same (Examples 2a to 2c) and that in which the first refractive index n1 of the first organic layer 310 and the fourth refractive index n4 of the third organic layer 340 are the same, and the second refractive index n2 of the light emitting layer 320 is smaller than the first refractive index n1 (or the fourth refractive index n4) (Examples 4a to 4c).

FIG. 7 is a schematic cross-sectional view illustrating a portion of an organic light emitting diode according to another embodiment of the present disclosure.

A principle of improving a viewing angle on the side in the third pixel area (see SP3 of FIG. 3) of the organic light emitting diode according to an embodiment of the present disclosure will be described in detail with reference to FIG. 7.

As shown in FIG. 7, in the organic light emitting diode according to an embodiment of the present disclosure, a first organic layer 1st layer 310, a light emitting layer EML 320, and a second organic layer 2nd layer 330 are sequentially formed from the bottom of the drawing. According to an embodiment of the present disclosure, the first organic layer 1st layer 310 may have a first refractive index n1, the light emitting layers EML 320 may have a second refractive index n2, and the second organic layer 2nd layer 330 may have a third refractive index n3.

According to another embodiment of the present disclosure, the first refractive index n1 of the first organic layer 310 may be greater than the third refractive index n3 of the second organic layer 330, and the first refractive index n1 of the first organic layer 310 and the second refractive index n2 of the light emitting layer 320 may be the same. By forming in this way, a viewing angle in a side surface of light emitted from the third pixel area (see SP3 of FIG. 3) may be improved.

Since the first refractive index n1 and the second refractive index n2 are the same, light that sequentially passes the first organic layer 310 and the light emitting layer 320 may not be refracted and pass. In this case, the light may travel toward the boundary surface between the light emitting layer 320 and the second organic layer 330 at a first angle a1', and since the second refractive index n2 of the light emitting layer 320 is greater than the third refractive index n3 of the second organic layer 330, the light may be refracted at a second angle b1' and emitted from the boundary surface between the light emitting layer 320 and the second organic layer 330. In this case, the second angle b1' may be formed to be greater than the first angle a1'. The first angle a1' may be defined as an angle formed by a normal line of an boundary surface between the light emitting layer 320 and the second organic layer 330 and the light traveling toward the boundary surface between the light emitting layer 320 and the second organic layer 330, and the second angle b1' may be defined as an angle formed by the normal line of the boundary surface between the light emitting layer 320 and the second organic layer 330 and the light traveling away from the boundary surface between the light emitting layer 320 and the second organic layer 330.

Meanwhile, the first angle a1' and the second angle b1' may be adjusted to a level according to knowledge of the art so that the total reflection of the light may not be occur at each boundary surface. Thus, the light may not be trapped inside the light emitting layer 320 or the second organic layer 330.

According to another embodiment of the present disclosure, since light traveling in a direction away from the boundary surface between the light emitting layer 320 and the second organic layer 330 is emitted at the second angle b1' greater than the first angle a1', the luminance on the side of the organic light emitting diode according to another embodiment of the present disclosure may increase, and thus the viewing angle on the side of the display device may be improved.

Table 7 shows the luminance at an angle of 45 degrees with respect to a difference value between the first refractive index n1 of the first organic layer 310 and the third refractive index n3 of the second organic layer 330 in a case in which the organic light emitting diode according to another embodiment of the present disclosure is the third pixel area SP3 of FIG. 3. In this case, the luminance measured at an angle of 45 degrees in Examples 7a to 7c is relatively shown based on 100% of the luminance measured at an angle of 45 degrees in Comparative Example 3.

**[table 7]**

| | n1-n3 | n1 | n2 | n3 | Luminance(%, @45°) |
|---|---|---|---|---|---|
| Comparative examples | -0.07 | 1.84 | 1.83 | 1.91 | 100% |
| Example 7a | 0.15 | 2 | 2 | 1.85 | 122% |
| Example 7b | 0.2 | 2 | 2 | 1.8 | 120% |
| Example 7c | 0.25 | 2 | 2 | 1.75 | 119% |

As shown in Table 7, in the examples 7a, 7b, and 7c in which the first refractive index n1 of the first organic layer 310 is greater than the third refractive index n3 of the second organic layer 330, higher luminance can be obtained compared to comparative example 3 in which the first refractive index n1 of the first organic layer 310 is smaller than the third refractive index n3 of the second organic layer 330.

As a result of examining Examples 7a to 7c and Comparative Example 3, since the first refractive index n1 of the first organic layer 310 is greater than the third refractive index n3 of the second organic layer 330, the luminance on a side surface of an organic light emitting diode according to another embodiment of the present disclosure may be improved, and thus the luminance viewing angle of the organic light emitting diode may be improved.

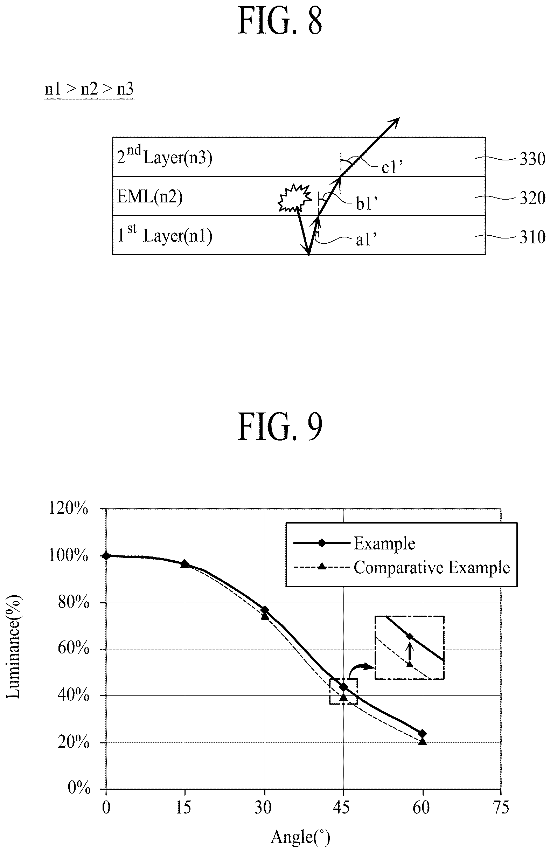

FIG. 8 is a schematic cross-sectional view illustrating a portion of an organic light emitting diode according to another embodiment of the present disclosure. Meanwhile, an embodiment of FIG. 8 is the same as an embodiment of FIG. 7, except for the relationship between the refractive index of the first organic layer and the refractive index of the light emitting layer, thus different configurations will be mainly described below.

According to another embodiment of the present disclosure, the first refractive index n1 of the first organic layer 310 may be greater than the third refractive index n3 of the second organic layer 330, the first refractive index n1 of the first organic layer 310 may be greater than the second refractive index n2 of the light emitting layer 320, and the second refractive index n2 of the light emitting layer 320 may be greater than the third refractive index n3 of the second organic layer 330. By forming in this way, a viewing angle in a side surface of light emitted from the third pixel area (see SP3 of FIG. 3) may be improved.

Since the first refractive index n1 of the first organic layer 310, the second refractive index n2 of the light emitting layer 320, and the third refractive index n3 of the second organic layer 330 are provided to decrease in order, the light may be refracted every time it passes through the boundary surface of each layer. Specifically, the light may travel toward the boundary surface between the first organic layer 310 and the light emitting layer 320 at a first angle a1' and since the first refractive index of the first organic layer 310 is greater than the second refractive index n2 of the light emitting layer 320, the light may be refracted at a second angle b1' and emitted from the boundary surface between the first organic layer 310 and the light emitting layer 320. In this case, the second angle b1' may be formed to be greater than the first angle a1'. The first angle a1' may be defined as an angle formed by a normal line of an boundary surface between the first organic layer 310 and the light emitting layer 320 and the light traveling toward the boundary surface between the first organic layer 310 and the light emitting layer 320, and the second angle b1' may be defined as an angle formed by the normal line of the boundary surface between the first organic layer 310 and the light emitting layer 320 and the light traveling away from the boundary surface between the first organic layer 310 and the light emitting layer 320.

Next, the light may travel toward the boundary surface between the light emitting layer 320 and the second organic layer 330 at the second angle b1', and since the second refractive index n2 of the light emitting layer 320 is greater than the third refractive index n3 of the second organic layer 330, the light may be refracted at the third angle c1' and emitted from the boundary surface between the light emitting layer 320 and the second organic layer 330. In this case, the third angle c1' may be formed to be greater than the second angle b1'. Therefore, the third angle c1' may be formed to be greater than the first angle a1'. The third angle c1' may be defined an angle formed by a normal line of an boundary surface between the light emitting layer 320 and the second organic layer 330 and the light emitted from the boundary surface between the light emitting layer 320 and the second organic layer 330.

Meanwhile, the first angle a1', the second angle b1', and the third angle c1' may be adjusted to a level according to knowledge of the art so that the total reflection of the light may not be occur at each boundary surface. Thus, the light may not be trapped inside the first organic layer 310, the light emitting layer 320, or the second organic layer 330.

According to another embodiment of the present disclosure, since light traveling in a direction away from the boundary surface between the light emitting layer 320 and the second organic layer 330 is emitted at the third angle c1' greater than the first angle a1', the luminance on the side of the organic light emitting diode according to another embodiment of the present disclosure increases, and thus the viewing angle on the side of the display device may be improved.

Table 8 shows the luminance at an angle of 45 degrees with respect to a difference value between the first refractive index n1 of the first organic layer 310 and the third refractive index n3 of the second organic layer 330 in a case in which the organic light emitting diode according to another embodiment of the present disclosure is the third pixel area SP3 of FIG. 3. In this case, the luminance measured at an angle of 45 degrees in Examples 8a to 8c is relatively shown based on 100% of the luminance measured at an angle of 45 degrees in Comparative Example 3.

**[table 8]**

| | n1-n3 | n1 | n2 | n3 | Luminance(%, @45°) |
|---|---|---|---|---|---|
| Comparative examples | -0.07 | 1.84 | 1.83 | 1.91 | 100% |
| Example 8a | 0.15 | 2 | 1.93 | 1.85 | 122% |
| Example 8b | 0.2 | 2 | 1.9 | 1.8 | 123% |
| Example 8c | 0.25 | 2 | 1.88 | 1.75 | 124% |

As shown in Table 8, in the examples 8a, 8b, and 8c in which the first refractive index n1 of the first organic layer 310 is greater than the third refractive index n3 of the second organic layer 330, higher luminance can be obtained compared to comparative example 3 in which the first refractive index n1 of the first organic layer 310 is smaller than the third refractive index n3 of the second organic layer 330. As a result of examining Examples 8a to 8c and Comparative Example 3, since the first refractive index n1 of the first organic layer 310 is greater than the third refractive index n3 of the second organic layer 330, the luminance on a side surface of an organic light emitting diode according to another embodiment of the present disclosure may be improved, and thus the luminance viewing angle of the organic light emitting diode may be improved. Furthermore, referring to Tables 7 and 8, it may be seen that the luminance in which the second refractive index n2 of the light emitting layer 320 is smaller than the first refractive index n1 of the first organic layer 310 (Examples 8a to 8c), is relatively higher than that in which the first refractive index n1 of the first organic layer 310 and the second refractive index n2 of the light emitting layer 320 are same (Example 7a to 7c).

FIG. 9 is a graph showing luminance of light according to an angle of viewing an organic light emitting diode according to an embodiment of the present disclosure. Specifically, FIG. 9 is a graph showing how a luminance value relatively changes according to an angle at which an organic light emitting device according to an embodiment of the present disclosure is viewed, when the luminance at the front side is 100%. In this case, comparative example relates to the case where the first refractive index of the first organic layer is smaller than the second refractive index of the second organic layer, and example relates to the case where the first refractive index of the first organic layer is larger than the second refractive index of the second organic layer.

As shown in FIG. 9, the relative intensity of luminance according to the viewing angle of the organic light emitting device according to an embodiment is greater than the relative intensity of luminance according to the viewing angle of the organic light emitting device according to the comparative example. Specifically, looking at the luminance at 45 degree angles, it can be seen that the comparative example has a luminance slightly lower than 40%, whereas the example has a luminance higher than 40%.

Consequently, according to an embodiment of the present disclosure, when the first refractive index n1 of the first organic layer 310 is greater than the third refractive index n3 of the second organic layer 330, it may be confirmed that the luminance on the side may increase.

Meanwhile, Table 9 is a table showing relative luminance at an angle of 45 degrees measured according to a difference (△n) between the first refractive index n1 of the first organic layer 310 and the third refractive index n3 of the third organic layer 330 in an organic light emitting diode according to an embodiment of the present disclosure. In this case, in Table 9 below, the luminance of Examples 9b to 9g refers to the relative luminance when the luminance measured at the angle of 45 degrees of Example 9a is 100%.

**[table 9]**

| | n1 | n3 | Δn(n1-n3) | Luminance(%, @45°) |
|---|---|---|---|---|
| Example 9a | 2 | 1.95 | 0.05 | 100% |
| Example 9b | 2 | 1.85 | 0.15 | 119% |
| Example 9c | 2 | 1.8 | 0.2 | 123% |
| Example 9d | 2 | 1.75 | 0.25 | 128% |
| Example 9e | 2 | 1.65 | 0.35 | 126% |
| Example 9f | 2 | 1.55 | 0.45 | 124% |
| Example 9g | 2 | 1.5 | 0.5 | 123% |

As shown in Table 9, it may be seen that luminance on the side surface is improved when the first refractive index n1 is formed to be greater than the third refractive index n3. Preferably, when the difference △n between the first refractive index n1 and the third refractive index n3 is 0.15 to 0.5 (0.15 to 0.5 means that it is 0.15 or more and 0.5 or less), luminance (%) at an angle of 45 degrees may be further increased, and thus, a viewing angle on the side surface may be further improved. Meanwhile, when the difference △n between the first refractive index n1 and the third refractive index n3 exceeds 0.5, since the light trapped inside the organic light emitting device increases as total reflection occurs in the first organic layer 310 or the second organic layer 330, the luminance on the side may not increase further, but may rather decrease. Furthermore, referring to FIG. 9 and Table 9, according to an embodiment of the present disclosure, it is seen that when the first refractive index n1 of the first organic layer 310 is greater than the third refractive index n3 of the second organic layer 330, the luminance on the side surface is further improved, preferably, when the difference △n between the first refractive index n1 of the first organic layer 310 and the third refractive index n3 of the second organic layer 330 is 0.15 to 0.5, the luminance on the side surface is further improved.

Table 10 shows the luminance measured at an angle of 45 degrees after setting a ratio of a difference value between the first refractive index n1 of the first organic layer 310 and the second refractive index n2 of the light emitting layer 320 to a difference value between the second refractive index n2 of the light emitting layer 320 and the third refractive index n3 of the second organic layer 330, differently. In this case, in Table 10, the luminance of Examples 10a to 10e excluding 10c represents the relative luminance when the luminance measured at the angle of 45 degrees of Example 10c is 100%.

**[table 10]**

| | n1-n2 | n2-n3 | (n1-n2):(n2-n3) | Luminance(%, @45°) |
|---|---|---|---|---|
| Example 10a | 0.04 | 0.21 | 4:21 | 94% |
| Example 10b | 0.08 | 0.17 | 8:17 | 97% |
| Example 10c | 0.12 | 0.13 | 12:13 | 100% |
| Example 10d | 0.16 | 0.09 | 16:09 | 94% |
| Example 10e | 0.21 | 0.04 | 21:04 | 90% |

As shown in Table 10, when the ratio of the difference between the first refractive index n1 of the first organic layer 310 and the second refractive index n2 of the light emitting layer 320 to the difference between the second refractive index n2 of the light emitting layer 320 and the third refractive index n3 of the second organic layer 330 is 4:21 to 16:9, luminance of 94% or more may be obtained, and thus a viewing angle on a side surface may be further improved. In addition, as can be seen from Table 10, when comparing Example 10a with Example 10e, it can be seen that the luminance at the side (45 degrees) is 94% in the case of Example 10a, while the luminance at the side is 90% in the case of Example 10e. Furthermore, when comparing Example 10b with Example 10d, it can be seen that the luminance at the side is 97%in the case of Example 10b, whereas the luminance is 94% in the case of Example 10d. As a result, when the difference between the first refractive index n1 of the first organic layer 310 and the second refractive index n2 of the light emitting layer 320 is smaller than the difference between the second refractive index n2 of the light emitting layer 320 and the third refractive index n3 of the second organic layer 330, an organic light emitting device having a further improved viewing angle may be implemented.

Table 11 below shows the luminance measured at a 45° angle when the first refractive index n1 of the first organic layer 310 is greater than or equal to the second refractive index n2 of the light emitting layer 320 (Example 11), and the luminance measured at a 45° angle when the first refractive index n1 of the first organic layer 310 is less than the second refractive index n2 of the light emitting layer 320 (Comparative Examples 11a to 11c).

**[table 11]**

| | n1-n2 | n2-n3 | n2 | Luminance(%, @45°) |
|---|---|---|---|---|
| Example 11 | 0.12 | 0.13 | 1.88 | 100% |
| Comparative example11a | -0.1 | 0.35 | 2.1 | 89% |
| Comparative example11b | -0.2 | 0.45 | 2.2 | 85% |
| Comparative example11c | -0.3 | 0.55 | 2.3 | 84% |

As shown in Table 11, it may be seen that the luminance in which the first refractive index n1 of the first organic layer 310 is smaller than the second refractive index n2 of the light emitting layer 320 (Comparative Examples 11a to 11c) is smaller than that in which the first refractive index n1 of the first organic layer 310 is greater than or equal to the second refractive index n2 of the light emitting layer 320 (Example 11). As a result, according to an embodiment of the present disclosure, when the first refractive index n1 of the first organic layer 310 is greater than or equal to the second refractive index n2 of the light emitting layer 320, high luminance in the side surface may be obtained.

Accordingly, the present disclosure may have the following advantages.

According to an embodiment of the present disclosure, since the first refractive index of the first organic layer disposed on the first electrode is greater than the third refractive index of the second organic layer disposed under the second electrode, an organic light emitting diode having high luminance on the side may be implemented.

According to an embodiment of the present disclosure, since the first refractive index of the first organic layer disposed on the first electrode is greater than the second refractive index of the light emitting layer disposed on the first organic layer, and the second refractive index of the light emitting layer is greater than the third refractive index of the second organic layer disposed on the light emitting layer, an organic light emitting diode having high luminance on the side may be implemented.

According to an embodiment of the present disclosure, since the first refractive index of the first organic layer disposed on the first electrode is greater than the fourth refractive index of the third organic layer disposed on the first organic layer, the fourth refractive index of the third organic layer is greater than the second refractive index of the light emitting layer, and the second refractive index of the light emitting layer is greater than the third refractive index of the second organic layer disposed on the light emitting layer, an organic light emitting diode having high luminance on the side may be implemented.

According to an embodiment of the present disclosure, by implementing an organic light emitting diode having high luminance on the side, an organic light emitting diode and a display device having an improved side viewing angle may be implemented.

## Claims

1. An organic light emitting diode comprising:
a first electrode (200);
a first organic layer (310) disposed on the first electrode (200) and having a first refractive index;
a light emitting layer (320) disposed on the first organic layer (310) and having a second refractive index;
a second organic layer (330) disposed on the light emitting layer (320) and having a third refractive index; and
a second electrode (210) disposed on the second organic layer (330),
wherein the first refractive index is equal to or greater than the second refractive index,
and the second refractive index is greater than the third refractive index.

2. The organic light emitting diode according to claim 1, wherein the first refractive index is same as the second refractive index and the organic light emitting diode further comprises a third organic layer (340a, 340b) disposed between the first organic layer (310) and the light emitting layer (320), wherein a fourth refractive index of the third organic layer (340a, 340b) is the same as the first refractive index.

3. The organic light emitting diode according to claim 1, wherein the first refractive index is greater than the second refractive index and the organic light emitting diode further comprises a third organic layer (340a, 340b) disposed between the first organic layer (310) and the light emitting layer (320), wherein a fourth refractive index of the third organic layer (340a, 340b) is the same as the first refractive index.

4. The organic light emitting diode according to claim 1, wherein the first refractive index is greater than the second refractive index and the organic light emitting diode further comprises a third organic layer (340a, 340b) disposed between the first organic layer (310) and the light emitting layer (320), wherein a fourth refractive index of the third organic layer (340a, 340b) is smaller than the first refractive index, and greater than the second refractive index.

5. The organic light emitting diode according to any one of the preceding claims, wherein a difference between the first refractive index and the third refractive index is greater than or equal to 0.15 and less than or equal to 0.5, preferably the difference between the first refractive index and the second refractive index is smaller than a difference between the second refractive index and the third refractive index.

6. The organic light emitting diode according to claim 5, wherein a ratio of a difference between the first refractive index and the second refractive index to a difference between the second refractive index and the third refractive index is 4:21 to 16:9.

7. The organic light emitting diode according to any one of the preceding claims, wherein the first organic layer (310) includes at least one of a hole transport layer and a hole injection layer, and the second organic layer (330) includes at least one of an electron transport layer and an electron injection layer.

8. An organic light emitting diode comprising:
a first electrode (200);
a first organic layer (310) disposed on the first electrode (200) and having a first refractive index;
a light emitting layer (320) disposed on the first organic layer (310) and having a second refractive index;
a second organic layer (330) disposed on the light emitting layer (320) and having a third refractive index; and
a second electrode (210) disposed on the second organic layer (330),
wherein the first refractive index is greater than the third refractive index.

9. The organic light emitting diode according to claim 8, wherein the first refractive index is equal to or greater than the second refractive index.

10. The organic light emitting diode according to claim 8 or 9, further comprising:
a third organic layer (340a, 340b) disposed between the first organic layer (310) and the light emitting layer (320),
wherein a fourth refractive index of the third organic layer (340a, 340b) is equal to or smaller than the first refractive index, and is equal to or greater than the second refractive index.

11. The organic light emitting diode according to any one of the preceding claims, wherein the difference between the first refractive index and the second refractive index is smaller than a difference between the second refractive index and the third refractive index.

12. A display device comprising:
a substrate (100) including a first pixel area (SP1), a second pixel area (SP2), and a third pixel area (SP3); and;
an organic light emitting diode disposed in the first pixel area (SP1), the second pixel area (SP2), and the third pixel area (SP3),
wherein any one of the organic light emitting diodes disposed in each pixel area (SP1, SP2, SP3) includes a first electrode (200), a second electrode (210) disposed on the first electrode (200), a first organic layer (310) disposed to be in contact with an upper surface of the first electrode (200), a light emitting layer (320) disposed on the first organic layer (310), and a second organic layer (330) disposed on the light emitting layer (320) and disposed to be in contact with a lower surface of the second electrode (210),
wherein a first refractive index of the first organic layer (310) is equal to or greater than a second refractive index of the light emitting layer (320),
and the second refractive index of the light emitting layer (320) is greater than a third refractive index of the second organic layer (330).

13. The display device according to claim 12, wherein a difference between the first refractive index and the third refractive index is larger than 0.15 and less than 0.5 and/or a ratio of a difference between the first refractive index and the second refractive index to a difference between the second refractive index and the third refractive index is equal to or greater than 4:21, and equal to or less than 16:9.

14. The display device according to claim 12 or 13, wherein one organic light emitting diode of the organic light emitting diodes disposed in the first pixel area (SP1) and the second pixel area (SP2) further includes a third organic layer (340a, 340b) between the first organic layer (310) and the light emitting layer (320), and a fourth refractive index of the third organic layer is equal to or smaller than the first refractive index of the first organic layer and/or an organic light emitting diode disposed in the first pixel area (SP1) emits red light, an organic light emitting diode disposed in the second pixel area (SP2) emits green light, and an organic light emitting diode disposed in the third pixel area (SP3) emits blue light.

15. The display device according to any one of the claims 12-14, wherein the light emitting layer (320) of the organic light emitting diode disposed in the third pixel area (SP3) is directly provided on the first organic layer (310).
